Europäisches Patentamt

European Patent Office

Office européen des brevets

(19)

(11) **EP 0 936 628 A1**

(12) **EUROPEAN PATENT APPLICATION**

(43) Date of publication:
18.08.1999 Bulletin 1999/33

(51) Int. Cl.$^6$: **G11C 16/06**

(21) Application number: 98830066.1

(22) Date of filing: 13.02.1998

| | |
|---|---|
| (84) Designated Contracting States:<br>AT BE CH DE DK ES FI FR GB GR IE IT LI LU MC<br>NL PT SE<br>Designated Extension States:<br>AL LT LV MK RO SI | (72) Inventors:<br>• Gaibotti, Maurizio<br>  20031 Cesano Maderno (MI) (IT)<br>• Demange, Nicolas<br>  57160 Lessy (FR) |
| (71) Applicant:<br>STMicroelectronics S.r.l.<br>20041 Agrate Brianza (Milano) (IT) | (74) Representative:<br>Dini, Roberto, Dr. Ing.<br>Via Castagnole, 59<br>10060 None (Torino) (IT) |

(54) **Low voltage non volatile memory sense amplifier**

(57)     Sense amplifier circuit for non-volatile memories, of the type apt to compare a voltage relating to a memory cell current, flowing in a bitline of a memory cell, to a reference voltage, by means of the use of an amplifying means, comprising bias means apt to define a bias voltage on the bitline for the sensing operation. According to the invention, there are provided further quick biasing means (C2) of the bitline (BL), apt to cooperate with said bias means (CB) in defining the bias voltage (VBL) of the bitline (BL), supplying a current substantially greater than the memory cell current (ICELL), in reply to a disabling signal (DIS), said quick biasing means (C2) being also apt to disable itself before the said bias voltage (VBL) is reached.

Fig. 2

## Description

The present invention refers to a sense amplifier circuit for low-voltage non-volatile memories.

In the following, reference is made to conventional terms of the MOS (Metal Oxide Semiconductor) transistor technology.

In particular the word 'gate' indicates the control electrode, or control gate, of the MOS transistor, while the word 'drain' indicates the load or output electrode and the word 'source' the source or output electrode.

With 'non-volatile' memories the memories are meant, which do not lose the stored data when the circuit supply is off memories of this kind are the ROM (Read Only Memory), the EPROM (Erasable Programmable Read Only Memory), the EEPROM (Electrically Erasable Programmable Read Only Memory) and the EAROM (Electrically Alterable Read Only Memory).

In the EEPROM, in particular, the data to be memorized is stored substantially by means of a MOS transistor. Said MOS transistor comprises two gate electrodes, one being a control gate, electrically connected to the circuit and which receives the gate voltage, the other being a so called floating gate, separated from the control gate by means of an $SiO_2$ oxide barrier, into which it is buried.

Depending on the logic state to be memorized, by means of the application of appropriate voltages, a positive or negative charge is trapped inside the floating gate. In fact said charge is transferred by tunnel effect from the substrate to the floating gate, through the potential barrier built by the oxide layer, and trapped therein. The trapped charge acts on the voltage-current relationship of the transistor, so that a change of the threshold voltage of the transistor takes place, according to the type of the trapped charge inside the floating gate.

The memory cell formed by the MOS transistor may assume three different status, i.e. written, erased or virgin status, depending on the fact that the charge inside the floating gate is of one or the other type, or a charge has never been there.

The correlation between the logic state, the sign of the trapped charge and the cell status, written or erased, is a matter of choice and may change from a product to another according to the selected convention.

The logic state of a cell can be identified sensing the current flowing through it in known bias conditions. In fact, if a negative charge is trapped inside the floating gate, the transistor threshold is higher in respect of that of a virgin transistor, therefore with the same gate-source voltage a smaller current will flow. Viceversa, if a positive charge is trapped inside the floating gate, the threshold voltage is lower in respect of that of a virgin transistor, and the current is greater.

In fact, the detection of the logic state is made comparing the current of a cell to the current of a virgin cell in the same biasing conditions. The comparison is made by means of a so called sense amplifier.

The known sense amplifiers are substantially based on a current mirror arranged between two circuit branches, the one connected to a virgin cell and the other to an array of memory cells. Within said array of memory cells, the drains are connected to a common bitline, and a decoding circuit selects one of the cells by means of a suitable bus. The current analysis by means of the sense amplifier may take place only when all the connecting nodes of the cells have reached a steady state condition, in particular the node which is electrically connected to the bus, and, through the decoder, to the bitline It is very important that the said connecting nodes are loaded with the maximum possible speed, without however producing overvoltages in respect of the desired steady state value In fact any overvoltage could produce a malfunctioning of the sense circuit. The bitline is typically biased to a voltage comprised between 0.5 and 1.5 volts.

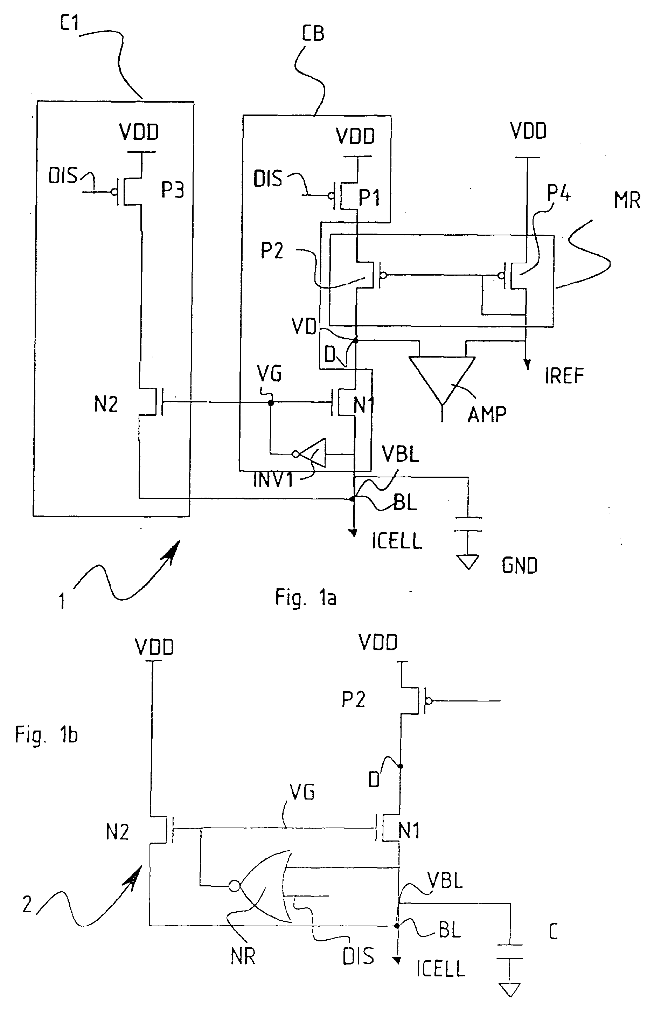

In fig 1a a known sense amplifier circuit is shown The sense amplifier circuit 1 is constituted by a current mirror MR, comprising two transistors P2, and P4, of the P-channel MOS type In one branch of the circuit a reference current IREF is flowing, generated by a reference cell, not shown, a repetition of the reference current is produced, according to the current mirror principle, in the circuit branch corresponding to the P4 transistor. On the other hand a current ICELL is generated by a memory cell also not shown. An amplifying stage AMP provides for the comparison of the two currents; beforehand a current-voltage conversion has to be made which is now described.

In effect a biasing circuit CB is provided, substantially constituted by a N-channel transistor N1 and by an inverter INV1, connected to a bitline BL, the capacitive behaviour of which is represented by a condenser C, in order to define a determined voltage VBL onto said bitline BL. For a more precise description, a bus should be distinguished from the bitline BL, said bus being separated from the bitline BL through a decoder, not shown, so that the voltage on the bus is different from the voltage on the bitline BL, due to the voltage drop of the decoder. For the sake of simplicity, the bus is not shown, the biasing circuit CB is directly connected to the bitline BL and and a similar situation is represented to that with a single cell to be measured. Furthermore a P-channel transistor P1 is source connected to the supply voltage VDD and drain connected to the transistor P2 of the current mirror MR, and is controlled by a disable signal DIS on its control electrode or gate said disable signal DIS is substantially a clock signal which times the charging cycles of the bitline BL, when the sense amplifier circuit 1 shall detect the memory cell status. The purpose of transistor P1 is therefore that of a logic switch, for enabling the P2 function as an active load during the detection, and may be considered as a part of the biasing circuit CB.

As known, inverter INV1 defines a gate voltage VG onto the gate of the transistor N1 and a bias voltage VBL onto the bitline BL. Said voltages VG and VBL depend on the inverting voltage of the inverter INV1 and on the threshold voltage of transistor N1, which is in the saturated state If the bias voltage VBL of the bitline VBL is brought to a value VBL0, which, as already said, is comprised between 0.5 and 1 volt, the voltage VD on a node D, drain of transistor N1, depends only on the current flowing through said transistor N1. If the cell to be measured has an high threshold voltage, hence it does not draw a current ICELL, the transistor P1, acting as an active load, brings the drain of transistor N1, node D, towards the supply voltage VDD, according to the known "pull-up" operation. Viceversa, if the cell to be measured has a low threshold voltage, hence it draws the ICELL current, the voltage VD on node D is equal to the VBL0 value, plus the overvoltage due to the flow of the current ICELL through the transistor N1. In order to perform an effective sensing of the cell, the whole current should flow through the transistor N1. The information about the logic state stored in the cell is obtained comparing the voltage VD with the voltage generated by the reference cell in a similar circuit

In the case of fig 1a, initially the disable signal DIS is high (supply voltage VDD), keeping the transistor P1 in cutoff state, while the bitline BL is brought to the ground GND by an external circuit not shown. The voltage VG is at the supply voltage VDD level too, due to the inverter INV1 effect. Later on, when the disable signal DIS goes down, the charging of the bitline BL begins. The bias voltage VBL reaches the VBL0 value.

The circuit of fig. 1a provides a charging circuit C1 for speeding up the charging process of the bitline BL. Said charging circuit C1 comprises a N-channel transistor N2, the gate thereof being connected to the gate of transistor N1 and the drain to the drain of a P-channel transistor P3, also controlled by the disable signal DIS. Hence, substantially, charging circuit C1 is a parallel circuit to that composed by transistor P1 and transistor N1, and cooperates with it for speeding up the charging of the bitline BL. To this purpose, transistor N2 shall be sized so as to have a smaller aspect ratio than the transistor N1, so that it draws a lower current and does not jeopardize the reading of the cell value. The advantage obtained for the charging of the bitline BL is therefore rather limited, because the transistor N2 must be kept small. One can avoid in part this problem using, instead of the disable signal DIS for the transistor P3, a different signal, having the descending edge synchronized on the disable signal DIS, but timed so as to cut off the transistor P3 just before that the bias voltage VBL reaches its steady state value. In this way the transistor N2 can be bigger and can quickly charge the bitline, while the charging process is brought to an end by the transistor N1 alone. Clearly this solution requires a very good timing of the signal controlling the transistor P3, because, if the charging circuit C1 is excluded too early, the charging process will last too much, while, if the charging circuit C1 is excluded too late, the read cell value will result a wrong one.

A known sense amplifier circuit 2, shown in fig 1b, on the contrary, substitutes the inverter with a logic NOR gate NR. The disable signal DIS is sent to the input of the logic NR gate that is not connected to the bitline BL, and allows to force the voltage VG to the ground

This however involves the disadvantage that, when the voltage VG has to rise again from the ground value to VDD, it takes some time through the P transistors of the logic gate NR, and on the other hand the said transistors cannot be made bigger, because this would change the value of the inverting voltage of the logic gate itself

The present invention has the aim of fixing the above cited problems and of indicating a sense amplifier for low-voltage non-volatile memories, the implementation of which is more effective and improved.

Within this task, the main aim of the present invention is that of indicating a sense amplifier for low-voltage non-volatile memories which allows to charge the bitline in a quick way without prejudice for the cell reading.

A further aim of the present invention is that of indicating a sense amplifier for low-voltage non-volatile memories which allows to charge the bitline in a quick way without the need of an external clock signal.

Another further aim of the present invention is that of indicating a sense amplifier for non-volatile memories which allows to avoid overvoltages during the charging process of the bitline

Another further aim of the present invention is that of indicating a sense amplifier for low-voltage non-volatile memories which allows to use an enlarged range of voltages.

In order to reach the above indicated aims, the present invention is directed to a sense amplifier circuit for low-voltage non-volatile memories having the characteristics indicated in the attached claims, which are integral part of the present description

Further aims, characteristics and advantages of the present invention will be clear from the following detailed description and from the attached drawings, given only as an explicatory non-limiting example, wherein

- figure 1a shows a first schematic diagram of a first sense amplifying circuit for non-volatile memories according to the prior art;
- figure 1b shows a second schematic diagram of a second sense amplifying circuit for non-volatile memories according to the prior art;
- figure 2 shows the schematic diagram of a sense amplifying circuit for non-volatile memories according to the present invention

• figure 3 shows the schematic diagram of a variant of the sense amplifying circuit for non-volatile memories of fig 2

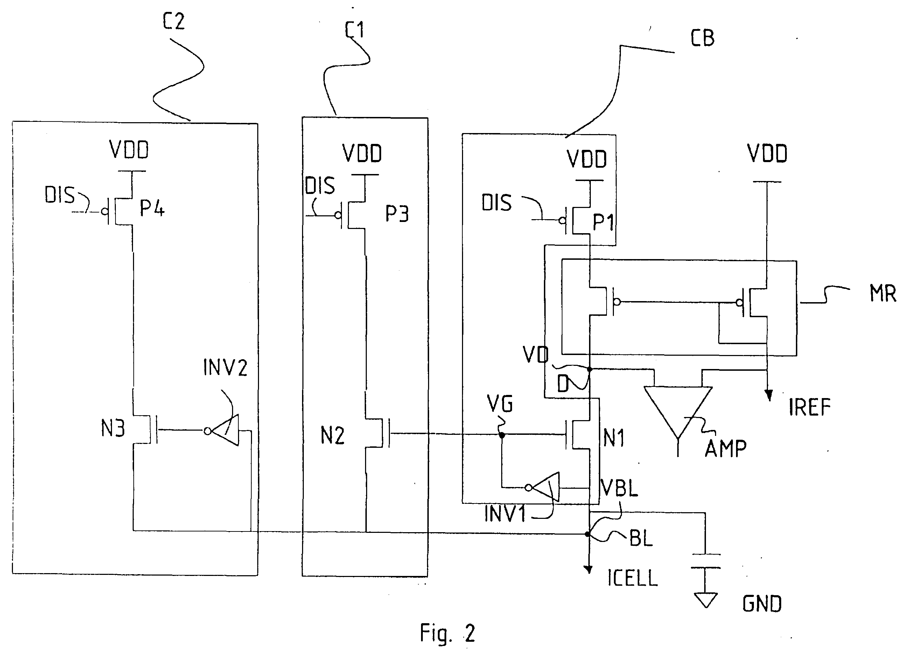

In figure 2 there is shown a sense amplifier circuit 3 according to the invention.

The sense amplifier circuit 3 comprises all the elements of the sense amplifier circuit 1 of fig 1 Moreover a quick charging circuit C2 has been added, in parallel to the charging circuit C1. The function of said quick charging circuit C2 is substantially that of charging the condenser C, associated with the bitline BL, before of the real phase of sensing the information contained in the cell. To this purpose, a transistor N3, of the N-channel MOS type, and an inverter INV2 are connected to the bitline BL, while a P-channel transistor P4 is connected between the drain of transistor N3 and the supply voltage VDD. Transistors N1, N2 and N3 are of the same type, i. e. for instance, natural low-threshold transistors

Transistors P1, P3 and P4 are all controlled by the disabling signal DIS. The inverter INV2 is so designed, that it has a lower threshold or inversion voltage than the inverter INV1, for instance, using a N-channel high aspect ratio transistor.

The operation may be described in three phases.

a) Quick precharging. Bitline BL starts from the ground voltage, i. e. 0V. On the descending edge of the disable signal DIS, the charging process begins through transistors N1, N2 and N3; the gates thereof are at the supply voltage value VDD. If condenser C is corresponding to a great bitline BL capacity, transistor N3 and transistor P4 may be chosen bigger than the other ones i. e. with greater driving capacity.

As the inversion voltage of inverter INV2 is lower than that of inverter INV1, voltage VGN3 will decrease more rapidly than voltage VGN1. At the end of phase a), VGN3 is less than the threshold voltage and VGN1 has in any case a greater value than the steady state value VBL0. The sizes of inverter INV1, of inverter INV2, of transistors N2 and N3, must be chosen so that transistor N3 is cut off when the bias voltage VBL is very close to VBL0.

b) End of precharging Transistor N3 goes cut off and the charging process is completed by transistor N2.

c) Sensing. When the bias voltage VBL reaches the VBL0 value, voltage VD can vary according to the cell status, i. e. its current ICELL, as known. As already said, the sizing of transistors N3 and P4 can vary depending on the value of condenser C. The load seen through transistor N1 is of less importance, since limited by transistor P1 in the function of active load The sizing of transistor N2 is limited by the condition that the current flowing through it during phase c) must be small in respect of the current flowing through transistor N1, which in turn must have a value the closest possible to that of cell current ICELL

Finally it is only transistor N3 which can be sized big in function of how quick the charging process of the bitline is desired to be.

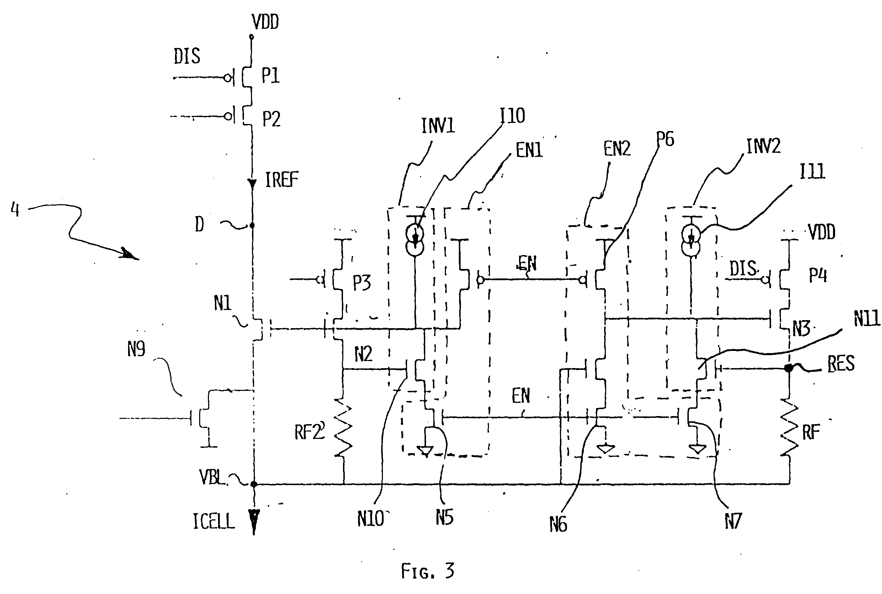

In fig 3 there is represented a sense circuit 4, which is a variant of the sense circuit 3 of fig. 2 In the representation of sense circuit 4 inverter INV1 and inverter INV2 are shown in detail and we can see that they are constituted substantially by a N-channel transistor N10 or N11 and a current generator I10 or I11 So a current generator I10 or I11 is substituted to the customary P-channel transistor having the gate connected to the gate of transistor N10 or N11, used for realizing CMOS technology inverters. Said current generator I10 or I11 can be realized, for instance, by means of a P-channel transistor, gate controlled by a stable driving current. Such a circuit pattern for inverters INV1 and INV2 allows to make the bias voltage VBL independent from supply voltage VDD, so allowing the use of an enlarged range of supply voltages.

Said sense amplifier circuit 4 shows also a first enabling circuit EN1 and a second enabling circuit EN2, respectively connected to the gate of transistor N1 and to the gate of transistor N3. Said first enabling circuit EN1 and second enabling circuit EN2 are realized by means of P-channel transistors P5 and P6 and N-channel transistors N5, N6, N7, which receive on the gate an enabling signal EN, which is the complementary one of the disabling signal DIS.

The enabling signal EN keeps the VG voltage on transistors N1, N2 and N3, at the supply voltage VDD value when we are not in the sensing phase. The enabling signal EN is, in this phase, a logic "0", which activates transistors P5 and P6. In the same way, enabling signal EN keeps transistors N5, N6 and N7 cut off, blocking paths between ground GND and the gates of transistors N1, N2, N3, even if the voltage on the bitline would be greater than the threshold voltage and tends to discharge said transistors

Sense circuit 4 comprises also a resistor RF connected between an input node RES of the inverter INV2 and the bitline BL, and a resistor RF2 connected between the input of inverter INV1 and the bitline BL. Assuming that resistor RF has a value of R1 ohm, it defines a voltage VRES on the input node RES of inverter INV2, and we get:

$$VRES=VBL+R1*IN3$$

where IN3 is the current flowing through transistor N3.

Hence the effect of resistor RF is that of reducing the gate-source voltage of transistor N3, as the voltage on the bitline rises, so avoiding charging the bitline too much and avoiding current peaks A similar function is performed by resistor RF2 in respect of transistor N2.

At last, in sense amplifier circuit 4, a N-channel transistor N9 is provided, connected to bitline BL, having the purpose of connecting it to the ground at the reception of a suitable signal, so discharging it completely.

From the description given the characteristics of the present invention will result clear, as well as the relevant advantages.

Conveniently the sense amplifier circuit according to the invention allows a quick charging process of the bitline, without affecting the phase of sensing the cell current

Moreover, the sense amplifier circuit according to the invention does not require the use of clock signals other than the enabling clock signals already used for separating the charging process from the sensing process

Moreover, the sense amplifier according to the invention allows an effective control of the oscillations and of the overvoltages on the bitline due to the precharging process.

It is clear that many variations to the sense amplifier circuit according to the invention and described as an example are possible for the man skilled in the art, without leaving the novelty principles of the invention, as well as that in the practical implementation the shown details may assume different shapes and be substituted by technically equivalent elements.

For instance, for obtaining the control of the oscillations on the bitline, it is possible to divide in two the N-channel transistors which are comprised in the inverters, connecting the gate of one of the two transistors to the bitline and the gate of the other transistor to the resistor.

**Claims**

1. Sense amplifier circuit for non-volatile memories, of the type apt to compare a voltage relating to a memory cell current, flowing in a bitline of a memory cell, to a reference voltage, by means of the use of an amplifying means, comprising bias means apt to define a bias voltage on the bitline for the sensing operation, characterized in that there are provided further quick biasing means (C2) of the bitline (BL), apt to cooperate with said bias means (CB) in defining the bias voltage (VBL) of the bitline (BL), supplying a current substantially greater than the memory cell current (ICELL), in reply to a disabling signal (DIS), said quick biasing means (C2) being also apt to disable itself before the said bias voltage (VBL) is reached

2. Sense amplifier circuit for non-volatile memories, according to claim 1, characterized in that the said quick biasing means (C2) substantially reproduces the circuit arrangement of the bias means (CB) and are arranged in parallel to it between the bitline (BL) and the supply voltage (VDD).

3. Sense amplifier circuit for non-volatile memories, according to claim 2, characterized in that the said quick biasing means (C2) is obtained through the use of one or more high driving capacity transistors.

4. Sense amplifier circuit for non-volatile memories, according to claim 1, characterized in that both the quick biasing means (C2) and the bias means (CB) comprise an inverter means (INV2, INV1), the input thereof being connected to the bitline (BL), and a transistor (N3, N1) having the control electrode connected to the inverter output, and an output electrode connected to the bitline, and comprise also an active load element (P4, P1) connected between the supply voltage (VDD) and said transistor (N3, N1)

5. Sense amplifier circuit for non-volatile memories, according to claim 4, characterized in that the inverter means (INV2) contained in said quick biasing means (C2) has a threshold intervention voltage which is less than that of the inverter means (INV1) contained in the bias means (CB).

6. Sense amplifier circuit for non-volatile memories, according to claim 5, characterized in that there are also provided auxiliary charging means (C1) of the bitline (BL), apt to cooperate with the bias means (CB) for defining the bias voltage (VBL), supplying a part of the memory cell current (ICELL) in reply to the disabling signal (DIS)

7. Sense amplifier circuit for non-volatile memories, according to claim 6, characterized in that there are provided overvoltages limiting means (RF, RF2), connected between the bitline and an input of the inverters (INV1, INV2) comprised in the quick biasing means (C2) and/or in the bias means (CB).

8. Sense amplifier circuit for non-volatile memories, according to claim 7, characterized in that said overvoltages limiting means (RF, RF2) is realized by means of resistors.

9. Sense amplifier circuit for non-volatile memories, according to claim 6, characterized in that the the inverters (INV1, INV2) comprised in the quick biasing means (C2) and/or in the bias means (CB), are realized by means of an N-channel transistor (N10, N11), the control electrode thereof being the inverter input, and of a stable current generation means (I10, I11), connected between the output electrode, or drain, of the N-channel transistor (N10, N11) and the supply voltage (VDD)

**10.** Sense amplifier circuit for non-volatile memories, according to claim 6, characterized in that there is provided an enabling signal (EN), substantially having an opposite phase of the disabling signal (DIS). controlling circuit means (EN1, EN2) for raising to the supply voltage, connected to the control electrode of the transistor (N1, N3) comprised in the quick biasing means (C2) and/or in the bias means (CB)

**11.** Sense amplifier circuit for non-volatile memories, according to claim 10, characterized in that the said circuit means (EN1, EN2) for raising to the supply voltage comprises switching means (N5, N6, N7) of the electrical path between the ground and the gate of the transistor (N1, N3) comprised in the quick biasing means (C2) and/or in the bias means (CB).

**12.** Method for sensing the current of a memory cell in non-volatile memories, of the type apt to compare a voltage relating to a memory cell current, flowing in a bitline of a memory cell, to a reference voltage, said voltages being supplied to an amplifying means, said sensing method providing a step of charging the bitline, wherein through bias means a bias voltage is charged onto the bitline, before a step of sensing the memory cell current, characterized by the fact of

> a) providing a signal (DIS), apt to activate the bias means (CB) during the charging step,
> b) using said signal (DIS) for contemporarily activating quick biasing means (C2), which supply a current greater than the memory cell current (ICELL) and charge more rapidly the bias voltage onto the bitline,
> c) providing within the quick biasing means (C2) switching means (INV2), connected to the bitline, which disables the operation of the quick biasing means (C2) before the bias voltage (VBL) on the bitline has been reached

**13.** Method for sensing the current of a memory cell in non-volatile memories, according to claim 12, characterized by the fact of

> c') realizing both the bias means (CB) and the quick biasing means (C2) substantially by means of a similar circuit arrangement, in particular an inverter circuit (INV1, INV2) having the input connected to the bitline, the inverter circuit (INV2) pertaining to the quick biasing means (C2) having an intervention threshold voltage which is less than the bias voltage (VBL).

**14.** Method for sensing the current of a memory cell in non-volatile memories, according to claim 12, characterized by the fact of

> d) providing auxiliary charging means (C1), apt to cooperate to the reaching of the bias voltage (VBL), supplying a part of the memory cell current (ICELL) after the quick biasing means have been disabled.

Fig. 1a

Fig. 1b

Fig. 2

Fig. 3

EP 0 936 628 A1

**European Patent Office**

**EUROPEAN SEARCH REPORT**

Application Number

EP 98 83 0066

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 363 340 A (ISHIKAWA KIMIYASU ET AL) 8 November 1994 | 1,2,4 | G11C16/06 |
| A | * column 5, line 46 - column 9, line 4; figures 4-6 * | 12,13 | |
| | --- | | |
| A | EP 0 478 440 A (SGS THOMSON MICROELECTRONICS) 1 April 1992 * column 1, line 34 - column 2, line 28; figure 1 * | 1,6,12, 14 | |
| | ----- | | |

TECHNICAL FIELDS SEARCHED (Int.Cl.6)

G11C

The present search report has been drawn up for all claims

| Place of search | Date of completion of the search | Examiner |
|---|---|---|
| THE HAGUE | 9 July 1998 | Cummings, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)